Europäisches Patentamt

European Patent Office

Office européen des brevets

(19)

(11) EP 0 939 487 A2

(12) **EUROPEAN PATENT APPLICATION**

(43) Date of publication:
01.09.1999 Bulletin 1999/35

(51) Int. Cl.$^6$: **H03H 17/02**

(21) Application number: 99103731.8

(22) Date of filing: 25.02.1999

(84) Designated Contracting States:
AT BE CH CY DE DK ES FI FR GB GR IE IT LI LU
MC NL PT SE
Designated Extension States:
AL LT LV MK RO SI

(30) Priority: 26.02.1998 IT TO980158

(71) Applicant:
Società Italiana per lo Sviluppo dell'Elettronica
S.I.SV.EL. S.p.A.
10060 None (TO) (IT)

(72) Inventor: Carini, Alberto
34139 Trieste (IT)

(54) **Filter for the equalization and/or linearization of non-linear systems**

(57) The present invention refers to a reverse filter of the p$^{th}$ order, p being a positive integer number, of a non linear system modelled by means of a Volterra filter, implemented by means of the cascade of the reverse filter of the linear part of the model and of p-1 cascaded cells; the main characteristic consists in the fact that each one of said cells comprises a first branch where there is present the output signal of the reverse filter of the linear part, and a second branch constituted by the cascade of the non linear part of the model and the reverse filter of the linear part of the model. Eliminating the reverse filter in cascade with the p-1 cells pre-linearizing and post- linearizing filters are obtained.

Fig.7

EP 0 939 487 A2

**Description**

The present industrial invention concerns a filter for equalizing / linearizing of non linear systems; the filter is obtained with the series development, in a cascade structure, of a linearizing or equalizing filter, deriving it from the reverse filter of the system's model.

A non linear system is considered as a system realizing a transformation or an operator transforming in a non linear way an input sequence x(n) into an output sequence y(n); such a transformation may be obtained by means of one or more devices, at least one of them being non linear; for instance a loudspeaker is a non linear system constituted by only one device, i.e. the loudspeaker itself. The assembly of a transmitter, a transmission means and a receiver is a non linear system constituted by a non linear device (the transmission means which produces distortion for instance due to the fading component, depending on the frequency) and by devices which shall be linear (transmitter and receiver).

One of the problems arising from the signal processing is the linearization or the equalization of non linear systems. Starting from a model of the non linear system, with the equalization we want to identify a filter to be put in series upstream or downstream with the non linear system, so that the overall response of the filter-system assembly is equal to the unity in the band B of the relevant frequencies.

This problem for instance is very important in the audio field with the bass register speakers, the so called woofers. Under 300 Hz, owing to the great displacement of the membrane, the non linearities due to the fixing means and to the non uniformity of the magnetic flux, create important non linear distortions. The concept of equalizing filter is tightly connected to that of reverse filter: the reverse filter, series connected to the non linear system, realizes the identity on the whole frequency range, while the equalizer realizes the identity only on the particular frequency band B, as said before.

A similar relationship exists between a perfect linearizing filter and a linearizing filter; wherein as perfect linearizing filter a filter is meant, which, series connected to the non linear system, realizes an overall response which is linear on the whole frequency range. For the sake of simplicity, we will assume that the linearizing filter produces an overall response which is equal to the transfer function A(q) alone of the linear part of the non linear system, q being a complex variable. A linearizing filter is called a pre-linearizing one if it is series connected upstream of the non linear system, while on the contrary case it is called a post-linearizing filter. In a similar way, we can speak of pre-equalizing filters and of post- equalizing filters, as well as of pre-inverse and post-inverse filters; but, while a pre-equalizing filter is equal to a post-equalizing filter, as well as a pre-inverse filter is equal to a post-inverse one, a pre-linearizing filter is not equal to a post-linearizing one, as will be explained later.

It is easy to verify that a linearizing filter can be obtained putting in series a linear filter having a transfer function equal to A(q) and the equalizing filter of the non linear system. In the case of pre-linearizing the linear filter is upstream of the equalizer while in the case of post-linearizing it is downstream.

Normally the most common technique for linearizing or equalizing non linear systems unites the system to a Volterra filter, i.e. a filter whose mathematical expression is the truncated Volterra series, that is having a limited number of nuclei, wherein a nucleus means a group of same order coefficients. The non linear model is then inverted using the reverse filter, that is also called the inverse of $p^{th}$ order; the inverse of $p^{th}$ order of a non linear model H has been defined by Schetzen, in the book "The Volterra and Wiener theories of non linear systems", New York Wiley 1980, as the system of $p^{th}$ order, which, cascade connected to H, originates a system the Volterra series of which shows void nuclei from the second to the $p^{th}$ order and an impulse response of the overall linear part equal to a unity pulse. A less limited of the inverse of $p^{th}$ order is given by Sarti and Pupolin in the article "Recursive techniques for the synthesis of a $p^{th}$ order inverse of a Volterra filter", European Transaction on Telecommunications, vol. 3, No. 4, July-August 1992, where it is permitted to the reverse filter of having nuclei of a greater order than p. In this way the synthesis of the reverse filter is easier.

The $p^{th}$ order inverse requires the inversion of the linear part of the non linear system; such a reverse is normally realized by means of a FIR (Finite Impulse Response) filter, as shown for instance in the article "Adaptive linearization of a loudspeaker" by Franklin X. Y. Gao & Martin Snelgrove, in Proceedings of International Conference On Acoustic, Speech and Signal processing, Toronto, May 1991. In this case the linearization is realized in an adaptive way, i.e. with the filters updated on every sample or group of input or output samples. The implementation is rather difficult and the identification of the inverse of the linear part of the system is affected by great phase and amplitude errors, which considerably deteriorate the performance of the linearizer. The method for linearizing acoustic reproducers proposed by Walter A. Frank in the article "An efficient approximation to the quadratic Volterra filter and its application in the real-time loudspeaker linearization", Signal Processing, Elsevier, vol. 45, No. 1, January 1995, is certainly easier to implement because the model is constituted by a product of linear filters, but has the same problems of the solution proposed by Gao and Snelgrove.

Object of the present invention is that of indicating an equalizing and/or linearizing filter which, avoiding the cited inconveniences, is both easy to implement and stable.

In order to reach the said object, the present invention has as its subject an equalizing and/or linearizing filter having the characteristics described in the attached claims, which are an integral part of the present description. Further objects and advantages of the present invention will be clear from the following detailed description and from the drawings, which are given as an explanatory and not limiting example only, wherein:

- Fig. 1 shows a reverse filter;
- Fig. 2 shows a pre-linearizing perfect filter;
- Fig. 3 shows a reverse filter according to the invention;
- Fig. 4 shows a pre-linearizing perfect filter according to the invention;
- Fig. 5 shows a post-linearizing perfect filter according to the invention;
- Fig. 6 shows a delay cell;
- Fig. 7 shows a particular implementation of the invention.

Even if the considerations which follow are applicable to every non linear system, as for instance the class of the cited Frank filters, the polynomial filters and those described in the A Carini, G.L. Sicuranza, V.J. Matthews article "On the inversion of certain non linear systems" in I.E.E.E. Signal Processing Letters, December 1997, for the sake of simplicity we will now examine a non linear system constituted by a $L^{th}$ order, memory length M, Volterra filter, which can be represented by the following expression:

$$y(n) = A(q)\,x(n) + N[x(n)] \qquad\qquad 1)$$

where $x(n)$ and $y(n)$ are respectively the input and output signals; $A(q)$ is, as said before, a linear operator acting on $x(n)$ and which can be expressed by:

$$A(q) = \sum_{i=0}^{M} a_j q^{-i} \qquad\qquad 2)$$

where $a_i$ are the first order coefficients, and $N[x(n)]$ represents the non linear part constituted by samples products $x(n)$ 582*1

$$N[x(n)] = \sum_{i=r}^{M}\sum_{j=i}^{M} c_{ij}\, x(n-i_1)\, x(n-j) \;+...+$$

$$+ \sum_{i1=r}^{M}\sum_{j2=i1}^{M}\sum_{iL=iL-1}^{M} h_{i1}\, x(n-i_1)\, x(n-i_2)\, ...\, (n-i_L) \qquad 3)$$

wherein the index r can be 0 or 1; $c_{ij}$ are the second order coefficients and $h_{i1, i2 ... iL}$ those of the $L^{th}$ order. As previously defined the group of the same order coefficients is called nucleus.

In the above cited Carini, Sicuranza and Mathews's article it is demonstrated that the reverse filter of the 1) is:

$$w(n) = A^{-1}(q)\, u(n) - A^{-1}(q)\, N[w(n)] \qquad\qquad 4)$$

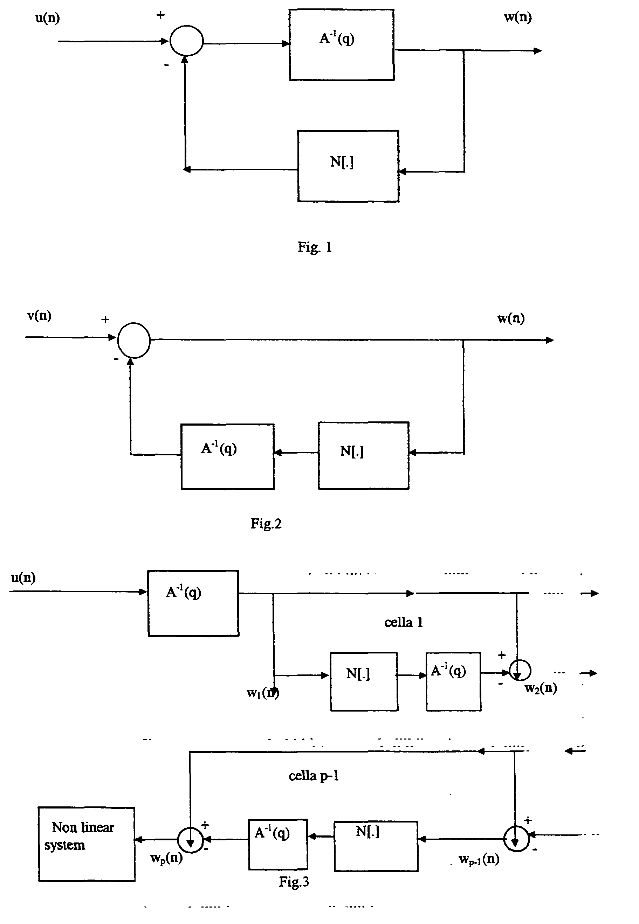

where $A^{-1}(q)$ is the inverse of $A(q)$. The 4) is represented in the block diagram of Fig. 1.

We point out that if in the 3) r=1 the filter of Fig. 1 can be physically implemented; if r=0 it cannot, because the feedback loop depends on values of the output signals which have not yet been calculated.

It is easy to verify that, connecting in cascade $A(q)$ and the filter 4), the perfect pre-linearizier of Fig; 2 is obtained, corresponding to the expression:

$$w(n) = v(n) - A^{-1}(q) \, N[w(n)] \qquad\qquad 5)$$

The post-linearizer can be obtained exchanging the positions of the two vlocks of the feedback loop of Fig. 2, and the 5) becomes:

$$w(n) = v(n) - N[A^{-1}(q) \, w(n)] \qquad\qquad 5')$$

As already said, often it is interesting of equalizing or linearizing only inside a given band B; indicating with $\tilde{A}^{-1}(q)$ the filter which equalizes $A(q)$ in the band B, the equalizer of expression 1) becomes:

$$w(n) = \tilde{A}^{-1}(q) \, u(n) - \tilde{A}^{-1}(q) \, N[w(n)] \qquad\qquad 6)$$

Analogously the pre-linearizer for th band B becomes:

$$w(n) = v(n) - \tilde{A}^{-1}(q) \, N[w(n)] \qquad\qquad 7)$$

If a response zero outside the band B is desired, it must be $\tilde{A}^{-1}(q) = 0$ outside band B.

Generally it is convenient that the input signal x(n) is limited to the band B alone, because, in the contrary case, the part of the signal outside said band originates a disturbance due to beats which cannot be eliminated with the linearizing or equalizing filter. Linearization and equalization are furthermore very sensitive to phase errors between $A(q)$ and $\tilde{A}^{-1}(q)$; if, for instance, at a given frequency, the phase difference is ™, the non linear distortion doubles rather than being eliminated.

The equalizing or linearizing filters seen up to now are polynomial recursive filters and therefore show little probability to be stable; if moreover in 1) is r=0, such filters are cannot be implemented. Furthermore the $\tilde{A}^{-1}(q)$ filter is normally difficult to implement because the recursive structure hinders the introduction of time delays in the response.

In order to avoid the aforesaid inconveniences the invention proposes to expand in series the linearizing or equalizing filter into a non recursive structure constituted by cells in cascade. In fact, if $A^{-1}(q)$ is stable, we can demonstrate that the sequence of systems defined by:

$$w_1(n) = A^{-1}(q) \, u(n) \qquad\qquad 8)$$

$$w_p(n) = A^{-1}(q) \, u(n) - A^{-1}(q) \, N[w_{p-1}(n)] \qquad\qquad 9)$$

converges to the system 4), i.e. to the perfect pre-linearizing filter when p tends to infinite, and that the system 9) is a $p^{th}$ order inverse of the 1) according to the said definition of Sarti and Pupolin. As the filter 4) is the exact inverse of system 1), and as, as known, the $p^{th}$ order inverse converges, for p tending to infinite, to the exact inverse if $A^{-1}(q)$ is stable, it is sufficient to demonstrate that the 9) is a $p^{th}$ order inverse of the 1), for proving that the 9) converges to the 4). The demonstration is made by induction. Connecting in cascade to the 1) the filter 8), i.e. the filter 9) with p=1, we obtain between input and output the relationship:

$$w_1(n) = x(n) + A^{-1}(q) \, N[x(n)] \qquad\qquad 10)$$

i.e.:

$$W_1(n) = x(n) + T_1(n)$$

where $T_1(n)$ is a Volterra operator of order greater than 1, as results from the equations 2) and 3); hence $w_1(n)$ is the output of a 1st order inverse of the 1). Indicating with $w_p(n)$ the output of a $p^{th}$ order inverse, i. e.:

$$w_p(n) = x(n) + T_p(n) \qquad\qquad 11)$$

with $T_p(n)$ a Volterra operator of order greater than p, it is easy to demonstrate that:

$$w_{p+1}(n) = A^{-1}(q)\, u(n) - A^{-1}(q)\, N[w_p(n)] \hspace{3cm} 12)$$

is the $p+1^{th}$ order inverse of the 1).

In fact, considering a post-inverse for which $u(n) = y(n)$ and substituting 11) in 12), we obtain:

$$w_{p+1}(n) = x(n) + A^{-1}(q)\, N[x(n)] - A^{-1}(q)\, N[x(n)+T_p(n)]= \hspace{2cm} 13)$$
$$= x(n) + A^{-1}(q)\, N[x(n)] - A^{-1}(q)\, N[x(n)]+T_{p+1}(n) = x(n) + T_{p+1}(n)$$

where $T_{p+1}(n)$ is a Volterra operator of order greater than p+1, as N[.] is a Volterra operator of order greater than 1. The 9) is also a $p^{th}$ order inverse of the 1). Analogously we can develop in series the filters resulting from expressions 5) and 5'), always assuming that such filters are stable

$$w_1 = v(n) \hspace{5cm} 14)$$

$$w_p(n) = v(n) - A^{-1}(q)\, N[w_{p-1}(n)]$$

for the perfect pre-linearizer, and

$$w_1 = v(n) \hspace{5cm} 15)$$

$$w_p(n) = v(n) - N[A^{-1}(q)\, w_{p-1}(n)]$$

for the perfect post-linearizer. Similar expressions can be found for equalizer, pre- and post-linearizer in the B band.

In particular we define $p^{th}$ order equalizer a filter which, connected in cascade with the non linear system in discussion, originates an overall system which, in the B band, corresponds to identity in absence of Volterra operators of an order greater than p.

The 9) may be represented by the block diagram of Fig. 3; a $p^{th}$ order inverse is therefore given by the cascade of the linear reverse filter $A^{-1}(q)$ and of p-1 cells in cascade as those inside the dashed line in Fig. 3, where there are shown the first and the last cascade cells. Every cell is constituted by a top path or branch, where there is present the output signal of the inverse of the linear part $A^{-1}(q)$, and by a bottom branch formed by the cascade of the non linear part N[.] of the model with the reverse filter of the linear part $A^{-1}(q)$.

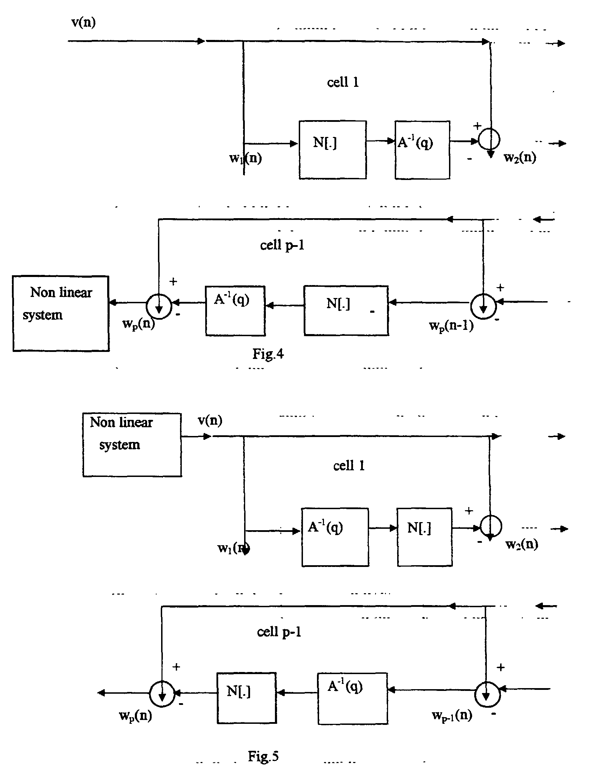

In Fig. 4 there is shown the block diagram of the $p^{th}$ order perfect pre-linearizing filter of expression 14), obtained with the cascade of p-1 cells as those inside the dashed line; the block diagram of the $p^{th}$ order perfect post-linearizing filter 15) is obtained exchanging the positions of $A^{-1}(q)$ and N[.], as in Fig. 5.

Of course, if we want the equalization or the linearization only inside a given bend B, it is necessary to substitute in expressions 9), 14), 15) and in Fig. 3, 4, and 5, $A^{-1}(q)$ with $\tilde{A}^{-1}(q)$, the latter being the equalizer of A(q) in the B band, as already said.

The filters of the Fig. 3, 4, and 5 are very attractive due to their structure, made by equal cells in cascade. Such structures however are slightly redundant for a simple equalization or linearization of the $p^{th}$ order. In fact in the first cells there are present N[.] nuclei which contributes to the output with Volterra nuclei of an order which is greater than p. In particular, numbering the left hand cells from 1 to p-1, all the N[.] nuclei having an order greater than i+1 may be eliminated from the $i^{th}$ cell, still obtaining an equalization, or a linearization according to the Sarti and Pupolin definition.

The proposed $p^{th}$ order filters show a complexity of calculation slightly greater than that of the corresponding filters to which they converge for p tending to infinite. The latter however show, as said, stability problem and cannot be implemented when in 1) the index r = 0. The filters of the Fig. 3, 4 and 5, and the corresponding filters for the B band alone, can on the contrary be implemented even if in the 1) r is equal to 0. Moreover such filters are not recursive and are always stable, provided that $A^{-1}(q)$ and $\tilde{A}^{-1}(q)$ are stable.

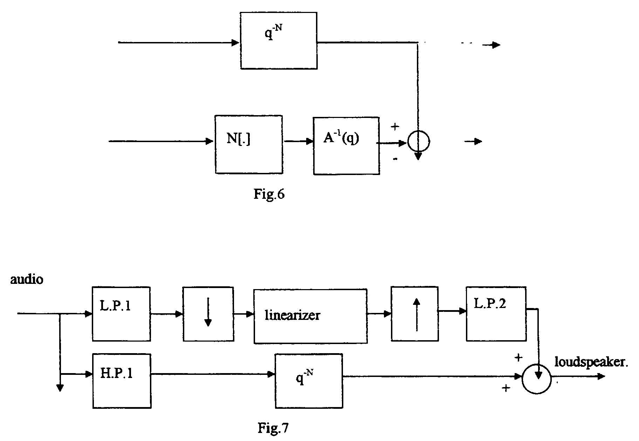

Furthermore it is possible to compensate for the delay introduced in the bottom branch of each cell introducing in the top branch a $q^{-N}$ delay, as shown in Fig. 6.

The cell filters according to the present invention may apply also if the non linear system is modelled by means of the cited Frank filters, or in case of more complicated models as are the recursive polynomial systems.

Starting from equalizing and linearizing filters based on the exact inverse of the model, we have obtained filters approximated by means of an easy to implement non recursive structure with cascaded cells.

It is clear that numerous variants can be applied to the equalizing and/or linearizing filter described as an example of the present invention, without exiting from the scope of the present invention.

The proposed linearizer can, for instance, be advantageously used in a system of loudspeakers comprising a woofer, a midrange and a tweeter. In this case the greater distortion take place in the band comprising the woofer and the lowest frequencies of the midrange, and it is therefore convenient to compensate only for such bend. As it is a reduced band, the Volterra filter modelling and the linearization have to be made after a suitable decimation of the audio samples, with the advantage of operating at a lower sampling frequency.

The system is shown in Fig. 7, where the down arrow is the decimator, the up arrow is the interpolator, LP.1 is the low-pass filter selecting the band where the linearization is made, L.P.2 is the low-pass filter for reconstructing the interpolated signal, H.P.1 is the high-pass filter complementary to L.P.1, $q^{-N}$ compensates for the top branch delay. L.P.1 and H.P.1 are not critical, while L.P.2 should deliver an amplitude as constant as possible and a linear phase in order to obtain a good linearization.

The linearization block of Fig. 7 represents the filter, which should be realized according to the teachings of the pre-linearizing filter shown in Fig. 4. Of course it is necessary to mathematically define the response curve of the loudspeakers in order to obtain the model of the device to be linearized (in this the loudspeaker). From this mathematical model a reverse filter should then be obtained and the above described linearization system should be applied.

Referring to formula 3), the linearizer can be implemented putting $L = p = 2$, a memory length $M = 51$ for the linear term and $M = 40$ for the quadratic term, while 3 is the factor to select for the decimation and interpolation.

## Claims

1. Reverse filter of the $p^{th}$ order, p being a positive integer number, of a non linear system modelled by means of a Volterra filter, implemented by means of the cascade of the reverse filter of the linear part of the model and of p-1 cascaded cells, characterized in that each one of said cells comprises a first branch where there is present the output signal of the reverse filter of the linear part, and a second branch constituted by the cascade of the non linear part of the model and said reverse filter of the linear part.

2. Reverse filter according to claim 1, characterized in that the modelling of the non linear system is not made by means of a recursive Volterra filter.

3. Reverse filter according to claim 1, characterized in that the modelling of the non linear system is made by means of the product of Frank type linear filters.

4. Reverse filter according to claim 1, characterized in that the modelling and the equalizing of the non linear system is made only within a predetermined frequency band.

5. Reverse filter according to claim 1, characterized in that in the first branch of every cell a delay is inserted so as to compensate the delay originated in the second branch (Fig. 6).

6. Equalizing system using a reverse filter according to one or more of the preceding claims.

7. Perfect pre-linearizing filter of the $p^{th}$ order, p being a positive integer number, of a non linear system modelled by means of a Volterra filter, implemented by means of the cascade of p-1 cascaded cells, characterized in that each one of the cells comprises a first branch where there is present the input signal, and a second branch constituted by the cascade of the non linear part of the model and the reverse filter of the linear part of the model (Fig. 4).

8. Perfect post-linearizing filter of the $p^{th}$ order, p being a positive integer number, of a non linear system modelled by means of a Volterra filter, implemented by means of the cascade of p-1 cells, characterized in that each one of the cells comprises a first branch where there is present the input signal, and a second branch constituted by the cascade of the linear part of the model and the reverse filter of the non linear part of the model (Fig. 5).

9. Linearizing filter according to claim 7 or 8, characterized in that the system modelling is made by means of a non recursive Volterra filter.

10. Linearizing filter according to claim 7 or 8, characterized in that the system modelling is made by means of the product of Frank type linear filters.

11. Linearizing filter according to claim 7 or 8, characterized in that the system modelling and linearizing is made only within a predetermined frequency band.

12. Linearizing filter according to claim 7 or 8, characterized in that in the first branch of every cell a delay is inserted so as to compensate the delay originated in the second branch.

**13.** Linearizing filter according to claim 7 or 8, characterized in that the non linear system is constituted by at least one loudspeaker.

**14.** Linearizing system using a linearizing filter according to one or more of the preceding claims.

**15.** Acoustic reproducer using a linearizing filter according to one or more of the preceding claims.

**16.** Acoustic reproducer according to claim 15 characterized in that the linearizing filter provides 1 cell and a memory length equal to 51 for the linear term and equal to 40 for the quadratic term, as well as a decimation and interpolation factor equal to 3.

u(n)        +                       $A^{-1}(q)$            w(n)

-

N[.]

Fig. 1

v(n)      +                                      w(n)

-

$A^{-1}(q)$      N[.]

Fig.2

u(n)      $A^{-1}(q)$

cella 1

$w_1(n)$    N[.]    $A^{-1}(q)$    +    $w_2(n)$

-

cella p-1

Non linear system    +    $A^{-1}(q)$    N[.]    +

$w_p(n)$   -                            $w_{p-1}(n)$   -

Fig.3

v(n)

cell 1

$w_1(n)$    N[.]    $A^{-1}(q)$    $w_2(n)$

cell p-1

Non linear system    $w_p(n)$    $A^{-1}(q)$    N[.]    $w_p(n-1)$

Fig.4

Non linear system    v(n)

cell 1

$w_1(n)$    $A^{-1}(q)$    N[.]    $w_2(n)$

cell p-1

$w_p(n)$    N[.]    $A^{-1}(q)$    $w_{p-1}(n)$

Fig.5

9

$$q^{-N}$$

$$N[.] \quad A^{-1}(q)$$

Fig.6

audio

L.P.1 | ↓ | linearizer | ↑ | L.P.2

H.P.1 | $q^{-N}$

loudspeaker.

Fig.7